# EUROPÄISCHE PATENTSCHRIFT

(11) **EP 0 897 557 B1**
(45) Veröffentlichungstag und Bekanntmachung des Hinweises auf die Patenterteilung: **14.08.2002**
(21) Anmeldenummer: 97922951.5
(22) Anmeldetag: 03.05.1997
(51) Int. Cl.: G03F 7/004, G03F 1/08

(54) **LITHOGRAPHISCHES VERFAHREN ZUR ERZEUGUNG VON NANOSTRUKTUREN AUF OBERFLÄCHEN**
LITHOGRAPHICAL PROCESS FOR PRODUCTION OF NANOSTRUCTURES ON SURFACES
PROCEDE LITHOGRAPHIQUE DE PRODUCTION DE NANOSTRUCTURES SUR DES SURFACES

(30) Priorität: 08.05.1996 DE 19618447
(43) Veröffentlichungstag der Anmeldung: 24.02.1999
(73) Patentinhaber: Studiengesellschaft Kohle mbH, 45470 Mülheim an der Ruhr (DE)
(72) Erfinder: REETZ, Manfred, T., D-45470 Mülheim an der Ruhr (DE); WINTER, Martin, D-45470 Mülheim an der Ruhr (DE); DUMPICH, Günter, Gerhard-Mercator-Universität, D-47048 Duisburg (DE); LOHAU, Jens, Gerhard-Mercator-Universität, D-47048 Duisburg (DE)
(74) Vertreter: von Kreisler, Alek, Dipl.-Chem.
(86) Internationale Anmeldenummer: EP9702264
(87) Internationale Veröffentlichungsnummer: WO9742548

(56) Entgegenhaltungen:
- EP-A- 0 788 149
- WO-A-94/11787
- FR-A- 2 337 892
- IBM TDB, Bd. 31, Nr. 8, 1989, Seiten 347-348, XP002038177
- J. OF VACUUM SCI. AND TECHN., Bd. 13, Nr. 3, 1995, WOODBURY, N.Y., Seiten 1553--1558, XP000536492 J. HULTEEN ET AL.: "Nanosphere Lithography"
- J. OF APPLIED PHYSICS, Bd. 66, Nr. 3, 1989, WOODBURY, N.Y., Seiten 1403-1410, XP000039861 M. GROSS ET AL.: "Ion-Beam direct-write mechanisms in palladium acetate films" in der Anmeldung erwähnt

## Beschreibung

Die vorliegende Erfindung betrifft ein neues lithographisches Verfahren, mit dem beliebige Nanometer-große Strukturen auf Oberflächen besonders leicht erzeugt werden können. Speziell geht es um das Schreiben von Strukturen, d. h. von Nanometer-großen Linien oder Punkten, die aus Metallen oder Metall-Legierungen bestehen.

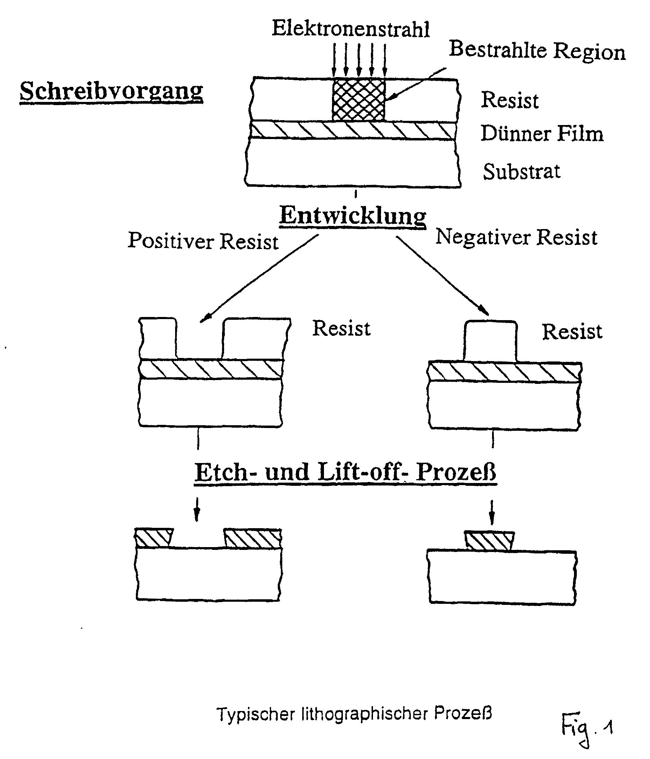

In der industriellen Mikroelektronik wird in der Regel die Photolithographie zur Erzeugung von Mikrometer-großen Strukturen, speziell von Leiterbahnen herangezogen (R. Enderlein, *Mikroelektronik,* Spektrum Akademischer Verlag, Heidelberg, 1993). Auf diesem Gebiet und bei anderen technischen Anwendungen ist man bestrebt, eine weitere Miniaturisierung der Strukturen zu erreichen. So läßt sich z. B. der Integrationsgrad von Silizium-Schaltkreisen durch Verkleinerung der Funktionselementeabmessungen erhöhen. Auf dem Gebiet der Submikrometer-Technologie erscheint gegenwärtig die Elektronenstrahllithographie als vielversprechend, aber auch die Röntgenstrahllithographie und die Ionenstrahllithographie werden bei Forschungsarbeiten eingesetzt. Die unterschiedlichsten Anwendungen der so erzeugten Oberflächenstrukturen sind potentiell möglich, z. B. integrierte Schaltkreise, magnetische Speicher, Sensoren, usw. [E. Reichmanis, L. F. Thompson, *Chem. Rev.* **89** (1989) 1273]. Unabhängig von der Energiequelle besteht ein lithograpischer Vorgang aus mehreren Stufen, wie das aus der Literaturstelle *Chem. Rev.* **89** (1989) 1273 entnommene Schema zeigt (Abb. 1).

Vor dem eigentlichen lithographischen Vorgang müssen die Precursor-Materialien erst hergestellt werden. Dies beinhaltet das Aufbringen eines dünnen Films (z. B. Halbleiter, Metall, usw.) auf ein Substrat. Ein gegen Strahlen empfindlicher Resist (Polymer) wird dann darauf aufgetragen.

Elektronenstrahllithographie wird auch verwendet, um nanostrukturierte magnetische Materialien für magnetische Speicher herzustellen. So wurden z. B. magnetische Linien und Säulen bestehend aus Nickel in Größen von 15 bis 200 nm erzeugt [P. R. Krauss, P. B. Fischer, S. Y. Chou, *J. Vac. Sci. Technol.* **B12** (1994) 3639; S. Y. Chou, P. R. Krauss, M. S. Wei, P. B. Fischer, *Scripta Metallurgica Materiala* **33** (1995) 1537]. Auch hier geht es um einen Mehrstufenprozeß, bei dem ein Schritt eine teuere und umständliche Metallverdampfung beinhaltet.

Eine andere Methode, auf Oberflächen Linien aus Metallen zu erzeugen, macht von der Ionenstrahllithographie Gebrauch [M. E. Gross, W. L. Brown, L. R. Harriott, K. D. Cummings, J. Linnros, H. Funsten, *J. Appl. Phys.* **66** (1989) 1403]. Danach wird ein aus Palladiumacetat [Pd(OAc)₂] bestehender Film auf eine Oberfläche aufgetragen und anschließend einem Ionenstrahl ausgesetzt. Nach dem Wegwaschen des überschüssigen Pd(OAc)₂ bleiben Pd-Linien. Allerdings sind sie relativ dick (0.5 µm) und weisen keine hohe Leitfähigkeit auf. Ein verwandtes Verfahren unter Verwendung eines Kupfersalzes (Cu₂(OH₂)₂[O₂C(CH₂)₄CH₃]₄) und Photolyse als Energiequelle erzeugt Kupferlinien, allerdings beträgt die kleinste Linienbreite 1 µm (1000 nm) [A. A. Avey, R. H. Hill, *J. Am. Chem. Soc.* **118** (1996) 237]. Eine Nanostrukturierung konnte dabei nicht erreicht werden.

Die gegenwärtige Forschung auf dem Gebiet der Nanostrukturierung von Oberflächen beinhaltet auch neue Techniken wie Rastertunnelmikroskopie (STM) und Rasterkraftmikroskopie (AFM) [P. Avouris, *Atomic and Nanometer Scale Modification of Materials: Fundamentals and Applications*, Kluwer Academic Publishers, Dordrecht, 1993; P. Avouris, *Acc. Chem. Res.* **28** (1995) 95; C. M. Lieber, J. Liu, P. E. Sheehan, *Angew. Chem.* **108** (1996) *748; Angew. Chem. Int. Ed. Engl.* **35** (1996) 686; L. A. Nagahara, H. Ohno, H. Tokumoto, *J. Photopolym. Sci. Techn.* **8** (1995) 669; R. Yang, D. F. Evans, W. A. Hendrickson, *Langmuir* **11** (1995) 211]. Es handelt sich jedoch um teuere und umständliche Verfahren.

Die vorliegende Erfindung betrifft ein einfaches lithographisches Verfahren, zur Erzeugung von Nanostrukturen auf Oberflächen, dadurch gekennzeichnet, daß stabilisierte Nanometer-große Übergangsmetall-Cluster bzw. Kolloide von Metallen der Gruppen 4, 5, 6, 7, 8, 9, 10, 11 oder 12 des Periodensystems, oder deren stabilisierte Metalloxid- oder Metallsulfid-Analoga jeweils in Form einer Lösung, auf eine Oberfläche als Film aufgetragen werden und dieser mit einem Elektronenstrahl gezielt belichtet wird, wobei nach Wegwaschen der nicht-belichteten Teile des Films, ggf. gefolgt von Tempern, definierte Strukturen auf der Oberfläche im Nanometerbereich erzeugt werden.

Während Metallpulver oder Drähte in gängigen Lösungsmitteln unlöslich sind, können bekanntlich die gleichen Metalle in Form von stabilisierten Metall-Clustern bzw. Metall-Kolloiden leicht in Lösung gebracht werden (G. Schmid, *Clusters and Colloids, VCH,* Weinheim, 1994). Metall-Cluster, häufig auch als Metall-Kolloide bezeichnet, werden von den unterschiedlichsten Stoffen stabilisiert, die somit eine unerwünschte Agglomeration der Metall-Teilchen verhindern. In der Literatur findet man verschiedene Verfahren, die es erlauben, stabilisierte Metall- und Bimetall-Cluster mit relativ enger Größenverteilung im Nanometerbereich herzustellen.

Zu den Stoffen, die Metall-Cluster und Bimetall-Cluster stabilisieren, gehören Tetraalkylammonium- und -phosphonium-Salze [M. T. Reetz, W. Helbig, *J. Am. Chem. Soc.* **116** (1994) 7401; M. T. Reetz, W. Helbig, S. A. Quaiser, *Chem. Mater.* **7** *(1995)* 2227; M. T. Reetz, S. A. Quaiser, *Angew. Chem.* **107** (1995) 2461; *Angew. Chem. Int. Ed. Engl.* **34** (1995) 2240; Studiengesellschaft Kohle mbH, EP-A-0 672 765 (Erfinder: M. T. Reetz, W. Helbig, S. A. Quaiser,, Priorität 14.3. und 06.12.1994); H. Bönnemann, in *Active Metals: Preparation, Characterization, Applications* (Hrsg. A. Fürstner), VCH, Weinheim, 1996; Studiengesellschaft Kohle mbH, PCT WO 92/18246 (Erfinder: H. Bönnemann, W. Brijoux, R. Brinkmann, E. Dinjus, R. Fretzen, B. Korall, Priorität vom 10.4.1991)]. Die stabilisierenden Tenside bilden eine Schutzhülle um die sphärischen Metallpartikel (M.T. Reetz et al, Science **267,** 367-369 (1995)).

Polymere wie Polyvinylpyrrolidon [J. S. Bradley, in *Clusters and Colloids* (Hrsg. G. Schmid), VCH, Weinheim, 1994] oder spezielle Liganden wie Phosphane oder Phenanthrolin-Derivate (G. Schmid, *Clusters and Colloids,* VCH, Weinheim, 1994) stabilisieren ebenfalls Metall-Cluster.

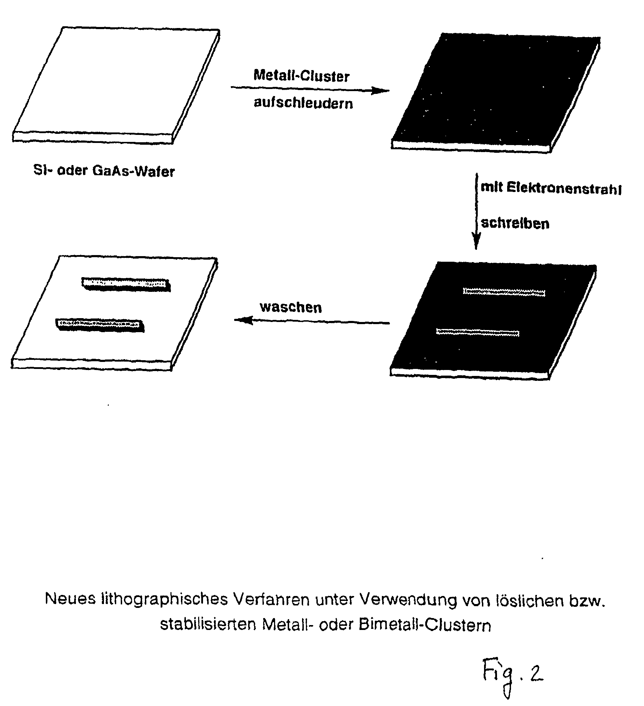

Im Rahmen der vorliegenden Erfindung werden Lösungen von solchen Metalloder Bimetall-Clustern oder Kolloiden, deren Größe sich von 0.3 bis 200 nm erstreckt, zunächst auf eine Oberfläche in Form eines dünnen Films aufgetragen, z. B. durch Aufschleudern (spin-coating) auf Galliumarsenid(GaAs)- oder Silizium(Si)-Wafern (chips). Durch Photo-, Ionenstrahl-, Röntgenstrahl- oder Elektronenstrahllithographie, vorzugsweise Elektronenstrahllithographie, wird dann der Metallkolloid-haltige Film belichtet, so daß an den belichteten Stellen die Metallkerne der stabilisierten Kolloide zu einem Muster agglomerieren unter gleichzeitigem Verlust des organischen Stabilisators. Die Geometrie der Muster bzw. der Strukturen auf der Oberfläche sind festgelegt bzw. definiert durch das computergesteuerte lithographische Vorgehen. Die Höhe der Strukturen wird u. a. durch die Menge der aufgeschleuderten Cluster bzw. der Schichtdicke des Films bestimmt. Der Clusterfilm an den unbelichteten Stellen und ggf. der Stabilisator oder Reste des Stabilisators auf dem Wafer werden dann in einem einfachen Waschverfahren entfernt, z. B. durch Waschen mit dem Lösungsmittel, das beim Aufschleudern des Metall-Clusters verwendet wurde. Übrig bleiben die metallischen oder bimetallischen Nanostrukturen (Linien oder Punkte). Das Verfahren ist in Abb. 2 schematisch dargestellt.

Überraschenderweise werden klar definierte Strukturen mit erstaunlich scharfen Profilen im Nanometerbereich erzeugt. Die Breite und Höhe der Linien kann im Bereich von 10 nm bis 500 µm bequem eingestellt werden. Die Länge kann zwischen 10 nm und 2 cm variiert werden. Punkte bzw. Säulen können ebenfalls erzeugt werden (Durchmesser: 10 nm bis 300 µm; Höhe: 10 nm bis 500 µm). Überraschend ist ferner der Befund, daß in relevanten Fällen die Leitfähigkeit der Metallstrukturen (z. B. Linien) den theoretisch maximalen Wert annehmen bzw. dem sehr nahe kommen.
Im Falle von Tetraalkylammonium- oder -phosphoniumsalz-stabilisierten Metallund Bimetall-Cluster können praktisch alle, in der Literatur beschriebenen Vertreter eingesetzt werden [M. T. Reetz, W. Helbig, *J. Am. Chem. Soc.* **116** (1994) 7401; M. T. Reetz, W. Helbig, S. A. Quaiser, *Chem. Mater.* **7** (1995) 2227; M. T. Reetz, S. A. Quaiser, *Angew. Chem.* **107** (1995) 2461; *Angew. Chem. Int. Ed. Engl.* **34** (1995) 2240;s. O. EP-A-0 672 765; H. Bönnemann, in *Active Metals: Preparation, Characterization, Applications* (Hrsg. A. Fürstner), VCH, Weinheim, 1996; s. o. PCT WO 92/18246].

Dabei läßt sich die Natur des Ammonium- oder Phosphoniumsalzes R₄N⁺X⁻ bzw. R₄P⁺X⁻ stark variieren. Typische Vertreter sind in den Patentanmeldungen EP-A-0 672 765 und PCT WO 92/18246 beschrieben. Vorzugsweise werden Tetrabutyloder Tetraoctylammoniumchorid, -bromid oder -acetat verwendet. Auch die Metalle lassen sich in einem breiten Rahmen variieren, so können z. B. die in den Patentanmeldungen EP-A-0 672 765 und PCT WO 92/18246 beschriebenen Metalle und Metall-Legierungen verwendet werden. Typische Metalle in Form der R₄N⁺X⁻ oder R₄P⁺X⁻-stabilisierten Cluster sind solche der Gruppe 4, 5, 6, 7, 8, 9, 10 und 11 (Gruppennumerierung nach IUPAC-Regeln 1989), insbesondere Ti, Mo, Fe, Ru, Co, Rh, Ni, Pd, Pt, Cu, Ag und Au. Typische Bimetall-Kombinationen sind Pd/Pt, Pt/Sn, Pd/Cu, Pd/Ni und Fe/Co.

Die beim Aufschleudern der Cluster verwendeten Lösungsmittel schließen die in der Chemie gängigen Vertreter ein, so z. B. THF, Toluol, Aceton, Dimethylformamid, Ethanol und Wasser. Vorzugsweise werden Kolloidlösungen in THF verwendet.

Im Falle von polymerstabilisierten Metall-Clustern können im Rahmen der vorliegenden Erfindung ebenfalls recht unterschiedliche Vertreter als Precursor gewählt werden, z. B. solche, die in der Monographie von G. Schmid (*Clusters and Colloids,* VCH, Weinheim, 1994) erwähnt sind. Vorzugsweise werden Polyvinylpyrrolidon- oder Polyethylenglycol-stabilisierte Pd-, Pt-, Cu-, Fe- oder Au-Cluster sowie Pd/Pt- oder Pd/Cu-Bimetall-Cluster verwendet.

Im Falle von Liganden-stabilisierten Metall-Clustern (G. Schmid, *Clusters and Colloids*, VCH, Weinheim, 1994) können im Rahmen der vorliegenden Erfindung ebenfalls recht unterschiedliche Vertreter gewählt werden. Dazu gehören Phosphan-stabilisierte Cluster von Metallen wie Pd, Rh, Cu oder Au, wobei Phosphane wie Triphenylphosphan vorzugsweise verwendet werden. Ähnliches gilt für Phenanthrolin-stabilisierte Metall-Cluster, deren Herstellung ebenfalls von G. Schmid beschrieben worden ist (G. Schmid, *Clusters and Colloids,* VCH, Weinheim, 1994).

Neben der Natur des Metalls, der Stabilisatorhülle bzw. des Liganden und des Lösungsmittels, kann auch die Größe der Metall- und Bimetall-Cluster variiert werden. Typischerweise erstreckt sich der Bereich von 0.3 bis 200 nm; vorzugsweise werden 0.5 bis 10 nm große Metall- oder Bimetall-Cluster eingesetzt.
Diverse Substrate können als Oberfläche dienen, so z. B. Si- oder GaAs-Wafer oder Metalloxid-Materialien mit glatten Oberflächen wie SnO₂. Vorzugsweise werden Si- oder GaAs-Wafer verwendet. Die Größe der Oberfläche kann zwischen 0.05 und 4 cm² betragen, vorzugsweise im Bereich von 0.1 bis 1 cm².

Die Metallcluster-haltigen Filme können mit Hilfe unterschiedlicher Verfahren auf die Oberfläche aufgetragen werden. Dazu gehören elektrophoretische Methoden, Langmuir-Blodgett-Verfahren und einfaches Aufschleudern (spin-coating), vorzugsweise wird das Aufschleudern gewählt.

Die Schichtdicke der aufgeschleuderten Cluster- bzw. Kolloid-haltigen Filme kann von 0,3 nm bis 2 µm variiert werden. Bei der Erzeugung von besonders kleinen Strukturen erstreckt sich der Bereich meist von 5 nm bis 200 nm.

Zur Erzeugung der Strukturen ist eine Belichtung mit einem Energiestrahl erforderlich, wobei die Elektronenstrahllithographie verwendet wird, wobei unterschiedliche Geräte benutzt werden können, insbesondere die in der Literatur beschriebenen modernen bzw. hochauflösenden Rasterelektronenmikroskope.

Das Wegwaschen des nicht-belichteten Clusters bzw. Kolloids wird mit Lösungsmitteln wie THF, Toluol, Dimethylformamid, Ethanol, Aceton oder Wasser durchgeführt, vorzugsweise mit THF oder Ethanol, ggf. in einem Ultraschallbad.

Die mit Metallstrukturen versehenen Wafer können je nach Bedarf thermisch nachbehandelt werden, z. B. durch Erhitzen im Bereich von 150 °C bis 400 °C, vorzugsweise bei 180 - 200 °C, ohne daß dabei die geschriebenen Strukturen kollabieren. Die Behandlung kann ohne oder mit einem H₂-Strom geschehen und dient zur weiteren Reinigung bzw. zum weiteren Entfernen von organischen Resten.

Die Dicke der geschriebenen Strukturen (Linien oder Punkte) hängt von verschiedenen Faktoren ab, die gezielt beeinflußt werden können. Dazu gehört der Metallgehalt des Clusters, die Dicke des aufgeschleuderten Cluster- bzw. Kolloid-Films und die Natur des Energiestrahls beim Belichtungsvorgang. Dabei muß die Dosis des Elektronenstrahls (µC/cm²) dem aufgeschleuderten Material und der Schichtdicke angepaßt werden, um Unter- oder Überbelichtung zu vermeiden. Bei Überbelichtung werden die Strukturen unscharf und verbreitert.
Ferner kann der lithographische Vorgang so gestaltet werden, daß z. B. beim Elektronenstrahl zunächst eine Linie in einer definierten Richtung gezogen wird, und daß dann in unmittelbarer Nachbarschaft erneut parallel zu dieser eine zweite Linie geschrieben wird. Dadurch wird eine breitere Linie (bzw. ein breiteres Muster) erzeugt, ein Vorgang, der zur Erzeug von breiten Strukturen beliebig oft wiederholt werden kann. Um das umgekehrte Ziel zu erreichen, nämlich möglichst dünne Linien zu erzeugen, darf nur einmal in eine Richtung geschrieben werden. Je höher die Auflösung des Gerätes bzw. des Rasterelektronenmikroskops, um so kleiner die erzeugten Strukturen.

Die Vorteile der Erfindung sind u. a.
1. Submikrometer-große Muster, also Nanostrukturen auf Oberflächen sind gezielt darstellbar.
2. Wenige und einfache Arbeitsschritte genügen, die keine aufwendige Metallverdampfung beinhalten.
3. Die Verwendung von leicht darstellbaren Metall-Clustern bzw. Kolloiden, deren Natur und Zusammensetzung laut Literatur auf einfachem Weg breit variiert werden können, bedeutet ebenfalls ein kostenkünstiges Verfahren.
4. Bi- bzw. polymetallische Strukturen lassen sich unter Verwendung der entsprechenden präformierten Kolloide leicht erzeugen (Legierungsstrukturen).
5. Durch geeignete Wahl des Metalls bzw. der Metalle lassen sich die elektrischen und/oder magnetischen (z. B. ferromagnetischen) Eigenschaften der lithographisch erzeugten Strukturen gezielt einstellen.

Das hier beschriebene lithographische Verfahren läßt sich auch auf nanostrukturierte Metalloxid- und Metallsulfid-Cluster bzw. Kolloide anwenden. Werden z. B. lösliche Cobalt(II)oxid-Cluster in einer THF-Lösung auf Oberflächen aufgeschleudert und der dadurch entstandene Film einem Elektronenstrahl ausgesetzt, so entstehen definierte Strukturen im Nanometerbereich. Ähnliches gilt, wenn nanostrukturierte Metallsulfide wie CdS als Precursor eingesetzt werden.

Die erfindungsgemäß fabrizierten Materialien finden Anwendung in verschiedenen Bereichen, und zwar immer dann, wenn bei der Herstellung von anwendungsrelevanten Produkten lithographische Verfahren involviert sind. Dazu gehört z. B. die Herstellung von integrierten Schaltungen in der Computerchip-Technologie, die Produktion von magnetischen Devices für magnetische Datenträger bzw. Speicher sowie die Fabrikation von Mikrosensoren. Dabei werden die erfindungsgemäß fabrizierten Materialien direkt als Komponenten eingesetzt, auch bei der Erzeugnung von Quantenpunkten und Quantendrähten (E. Corcoran, *Spektrum der Wissenschaft* **1991,** 76). Sie können aber auch indirekt genutzt werden, so z. B. als Stempel oder Masken bei der Mehrfacherzeugung von Bauteilen oder Komponenten in der Mikroelektronik oder Sensorik. So können z. B. die erfindungsgemäß erzeugten gemusterten Oberflächen als Stempel genutzt werden, eine einfache Alternative zur Herstellung von herkömmlichen Stempeln, die bekanntlich bei der Mehrfachproduktion von Bauteilen in der Mikroelektronik genutzt werden [z. B. Mikrokontakt-Drucken, d. h. microcontact printing nach G. M. Whitesides, et al, *Adv. Materials* ***7*** (1995) 471]. Die erfindungsgemäß hergestellten Materialien können auch als Maske bzw. Templat bei der Mehrfachherstellung von Nanometer-großen Strukturen im Rahmen der sogenannten Imprintlithographie [S. Y. Chou, P. R. Krauss, P. J. Renstrom, *Science* **272** (1996) 85] genutzt werden.

### Beispiel 1

### Herstellung von Palladium-Leiterbahnen unter Verwendung von 2 nm Kolloiden bzw. Clustern (68.80% Pd)

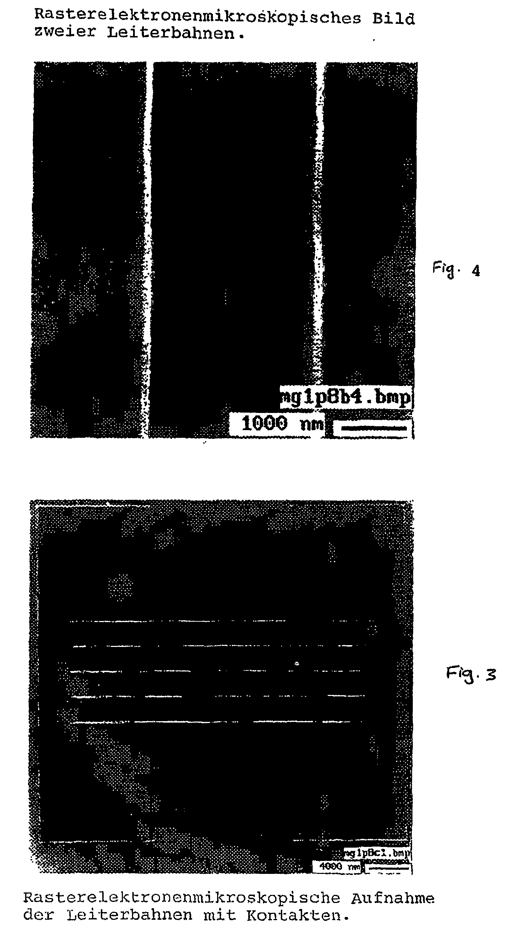

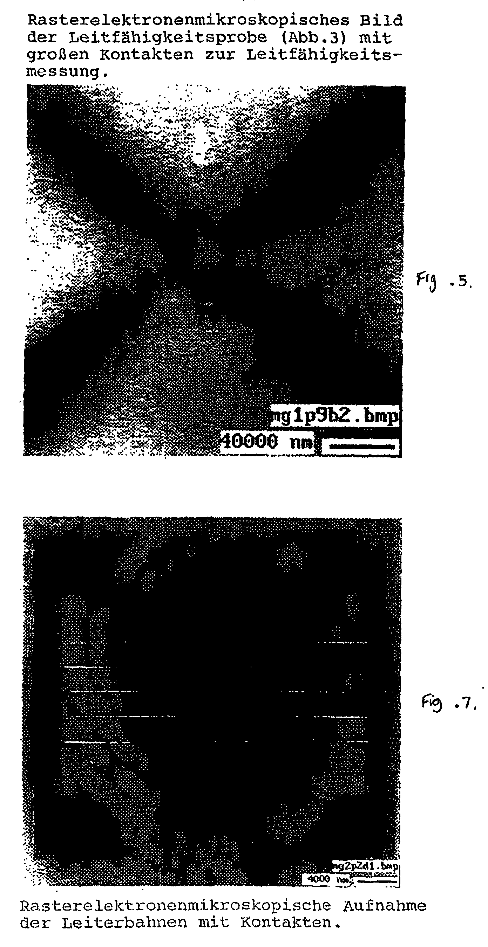

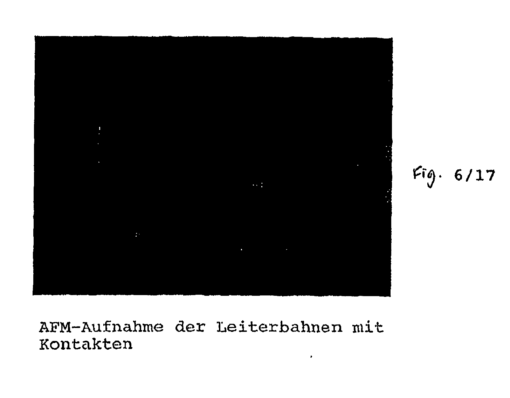

Unter Reinraumbedingungen wird zunächst eine Lösung von 150 mg Palladium-Tetraoctylammoniumbromid (Elementaranalyse: 68.80% Pd; die verbleibenden 31.2% bestehen aus Tetraoctylammoniumbromid, das als Stabilisator die Teilchen vor einer unerwünschten Agglomeration schützt) in 1 ml Tetrahydrofuran hergestellt. Die durch TEM ermittelte Größe der Kolloide liegt bei 2 nm bei sphärischer Geometrie. Auf zuvor in Aceton im Ultraschallbad gereinigten GaAs Substraten (3.9*3.9*0.5 mm) wird nun durch Aufschleudern ein Kolloidfilm erzeugt. Dafür werden 35 µl zuvor möglichst frisch filtrierter Kolloidlösung (Filtration durch 200 nm Teflonfilter) auf den GaAs-Wafer aufgetropft und der Aufschleuderprozess mit folgenden Parametern gestartet: Rotationsbeschleunigung 4500 Upm/s, Rotationsgeschwindigkeit 9000 Upm, Dauer 15 s. AFM-Untersuchungen zeigen, daß der entstandene Kolloidfilm eine Dicke von 163 nm bei einer mittleren Rauigkeit von <1 nm hat. Der Schreibvorgang erfolgt durch einbringen des GaAs-Wafers in ein Elektronenmikroskop und Belichten des Kolloidfilmes mit dem Elektronenstrahl. Als Layout wird eine Struktur bestehend aus fünf 20 nm breiten, 31 µm langen parallel verlaufenden Leiterbahnen gewählt, deren Enden durch Kontaktstreifen verbunden sind. Die Belichtung des GaAs-Wafers erfolgt im High-Magnification-Mode des Elektronenmikroskops jeweils mit folgenden Dosen: D=100000 µC/cm², D=200000 µC/cm², D=300000 µC/cm², wobei die Kontaktstreifen jeweils nur mit 10% der angegebenen Dosen belichtet werden. AFM-Untersuchungen der Proben zeigen, daß die Dosis D=200000 µC/cm² das beste Resultat zeigt, die Dicke des Kolloidfilmes sank an den Belichteten Stellen um 5 nm. Zur besseren Kontaktierbarkeit werden an diese Struktur im Low-Magnification-Mode große Kontakte für eine Vierpunkt-Leitfähigkeitsmessung mit D=4000 µC/cm² auf den Colloidfilm geschrieben. Die Entwicklung der Struktur erfolgt durch einfaches Waschen des GaAs-Wafers mit Tetrahydrofuran im Ultraschallbad, wobei der unbelichtete Kolloidfilm bedingt durch die Redispergierbarkeit des Pd-Kolloids weggewaschen wird, übrig bleiben die belichteten Bereiche. AFM-Untersuchung zeigt, daß Leiterbahnen von 30.662 µm Länge, 147 nm Breite und 85 nm Höhe mit zu gehörigen Kontakten geschrieben wurden. Durch Vierpunktmessung dieser Leiterbahnen ergibt sich R = 203 Ω/□, ρ=1725.5 µΩcm. Zur Verbesserung der Leitfähigkeit wird der GaAs-Wafer anschließend bei 185 °C, P=1 mbar 120 min getempert. Dabei reduziert sich die Dicke der Struktur auf 65 nm bei gleichbleibenden lateralen Abmessungen. Als Widerstand ergibt sich R = 27 Ω/□, ρ=175.5 µΩcm. Die folgenden Abbildungen 3 - 6 zeigen die Ergebnisse der rasterelektronenmikroskopischen und der rasterkraftmikroskopischen Untersuchungen.

### Beispiel 2

### Herstellung von Palladium-Leiterbahnen unter Verwendung von 2 nm Kolloiden bzw. Clustern (33.82% Pd)

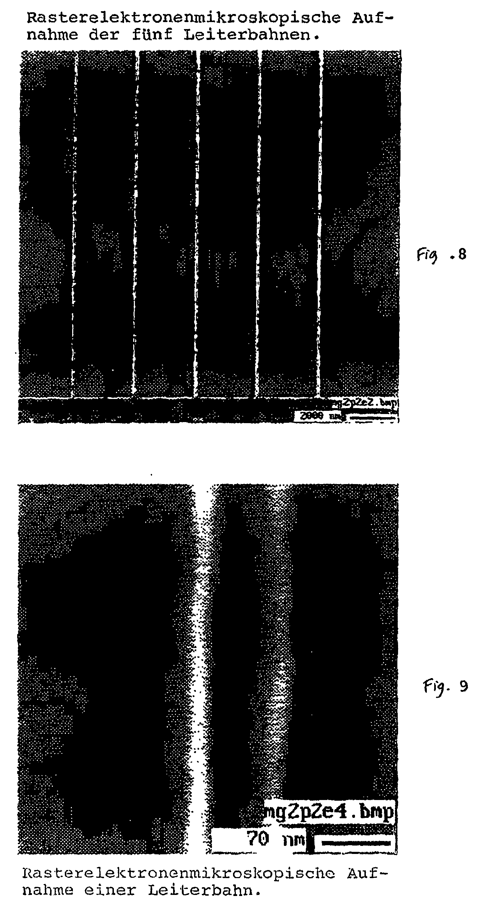

Unter Reinraumbedingungen wird zunächst eine Lösung von 67 mg Palladium-Tetraoctylammoniumbromid (Elementaranalyse: 33.82% Pd; die verbleibenden 66.18% bestehen aus Tetraoctylammoniumbromid, das als Stabilisator die Teilchen vor einer unerwünschten Agglomeration schützt) in 1 ml Tetrahydrofuran hergestellt. Die durch TEM ermittelte Größe der Kolloide liegt bei 2 nm bei sphärischer Geometrie. Auf zuvor in Aceton im Ultraschallbad gereinigten GaAs Substraten (3.9*3.9*0.5 mm) wird nun durch Aufschleudern ein Kolloidfilm erzeugt. Dafür werden 35 µl zuvor möglichst frisch filtrierter Kolloidlösung (Filtration durch 200 nm Teflonfilter) auf den GaAs-Wafer aufgetropft und der Aufschleuderprozess mit folgenden Parametern gestartet: Rotationsbeschleunigung 20000 Upm/s, Rotationsgeschwindigkeit 7000 Upm, Dauer 20 s.
Der Schreibvorgang erfolgt durch einbringen des GaAs-Wafers in ein Elektronenmikroskop und Belichten des Kolloidfilmes mit dem Elektronenstrahl. Als Layout wird eine Struktur bestehend aus fünf 20 nm breiten, 31 µm langen parallel verlaufenden Leiterbahnen gewählt, deren Enden durch Kontaktstreifen verbunden sind. Die Belichtung des GaAs-Wafers erfolgt im High-Magnification-Mode des Elektronenmikroskops jeweils mit folgenden Dosen: D=400000 µC/cm², D=600000 µC/cm², D=800000 µC/cm², wobei die Kontaktstreifen jeweils nur mit 10% der angegebenen Dosen belichtet werden. AFM-Untersuchungen der Proben zeigen, daß die Dosis D=600000 µC/cm² das beste Resultat zeigt. Zur besseren Kontaktierbarkeit werden an diese Struktur im Low-Magnification-Mode große Kontakte für eine Vierpunkt-Leitfähigkeitsmessung mit D=14000 µC/cm² auf den Kolloidfilm geschrieben. Die Entwicklung der Struktur erfolgt durch einfaches Waschen des GaAs-Wafers mit Tetrahydrofuran im Ultraschallbad, wobei der unbelichtete Kolloidfilm bedingt durch die Redispergierbarkeit des Pd-Kolloids weggewaschen wird, übrig bleiben die belichteten Bereiche. AFM-Untersuchung zeigt, daß Leiterbahnen von 31,736 µm Länge, 80 nm Breite und 70 nm Höhe mit zu gehörigen Kontakten geschrieben wurden. Durch Vierpunktmessung dieser Leiterbahnen ergibt sich R = 8.6 KΩ/□, ρ=60.2 mΩcm. Zur Verbesserung der Leitfähigkeit wird der GaAs-Wafer anschließend bei 185 °C, P=1 mbar 120 min getempert. Dabei reduziert sich die Dicke der Struktur auf 54nm bei gleichbleibenden lateralen Abmessungen. Als Widerstand ergibt sich R = 53 Ω/□, ρ=283.7 µΩcm. Das Tempern kann auch in einem H2-Strom durchgeführt werden. Die Abbildungen 7, 8 und 9 zeigen die entsprechenden rasterelektronenmikroskopischen Aufnahmen.

### Beispiel 3

### Herstellung von Palladium-Leiterbahnen unter Verwendung von 6 nm Kolloiden bzw. Clustern (46.00% Pd)

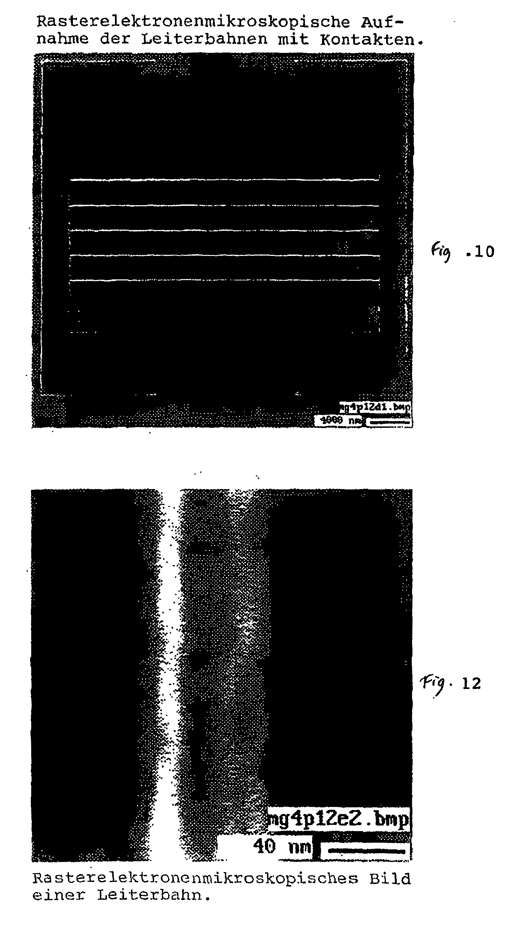

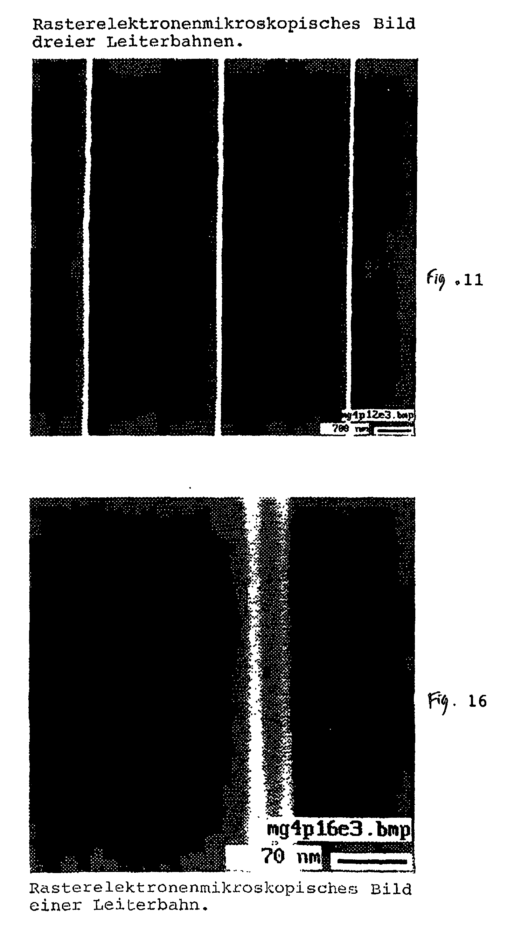

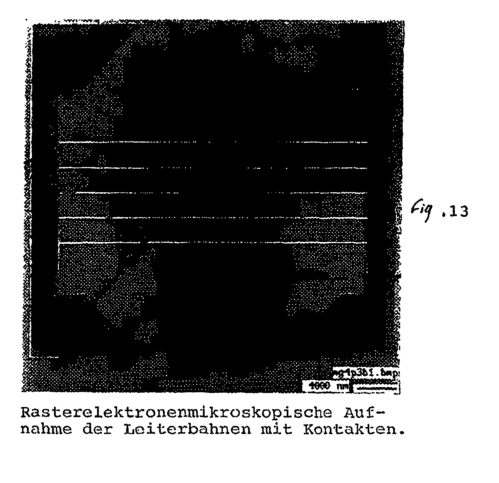

Unter Reinraumbedingungen wird zunächst eine Lösung von 150 mg Palladium-Tetraoctylammoniumbromid (Elementaranalyse: 46.00% Pd; die verbleibenden 54.00% bestehen aus Tetraoctylammoniumbromid, das als Stabilisator die Teilchen vor einer unerwünschten Agglomeration schützt) in 1 ml Tetrahydrofuran hergestellt. Die durch TEM ermittelte Größe der Kolloide liegt bei 6 nm bei sphärischer Geometrie. Auf zuvor in Aceton im Ultraschallbad gereinigten GaAs Substraten (3.9*3.9*0.5 mm) wird nun durch Aufschleudern ein Kolloidfilm erzeugt. Dafür werden 35 µl zuvor möglichst frisch filtrierter Kolloidlösung (Filtration durch 200 nm Teflonfilter) auf den GaAs-Wafer aufgetropft und der Aufschleuderprozess mit folgenden Parametern gestartet: Rotationsbeschleunigung 20000 Upm/s, Rotationsgeschwindigkeit 9000 Upm, Dauer 30 s.
Der Schreibvorgang erfolgt durch einbringen des GaAs-Wafers in ein Elektronenmikroskop und Belichten des Kolloidfilmes mit dem Elektronenstrahl. Als Layout wird eine Struktur bestehend aus fünf 20 nm breiten, 31 µm langen parallel verlaufenden Leiterbahnen gewählt, deren Enden durch Kontaktstreifen verbunden sind. Die Belichtung des GaAs-Wafers erfolgt im High-Magnification-Mode des Elektronenmikroskops jeweils mit folgenden Dosen: D=100000 µC/cm², D=200000 µC/cm², D=400000 µC/cm², D=600000 µC/cm², D=800000 µC/cm², wobei die Kontaktstreifen jeweils nur mit 10% der angegebenen Dosen belichtet werden. AFM-Untersuchungen der Proben zeigen, daß die Dosis D=600000 µC/cm² das beste Resultat zeigt. Zur besseren Kontaktierbarkeit werden an diese Struktur im Low-Magnification-Mode große Kontakte für eine Vierpunkt-Leitfähigkeitsmessung mit D=14000 µC/cm² auf den Kolloidfilm geschrieben. Die Entwicklung der Struktur erfolgt durch einfaches Waschen des GaAs-Wafers mit Tetrahydrofuran im Ultraschallbad, wobei der unbelichtete Kolloidfilm bedingt durch die Redispergierbarkeit des Pd-Kolloids weggewaschen wird, übrig bleiben die belichteten Bereiche. AFM-Untersuchung zeigt, daß Leiterbahnen von 31.966 µm Länge, 40 nm Breite und 170 nm Höhe mit zu gehörigen Kontakten geschrieben wurden. Durch Vierpunktmessung dieser Leiterbahnen ergibt sich R = 8071 Ω/□, ρ=137207 µΩcm. Zur Verbesserung der Leitfähigkeit wird der GaAs-Wafer anschließend bei 185 °C, P=1 mbar 120 min getempert. Dabei reduziert sich die Dicke der Struktur auf 130 nm bei gleichbleibenden lateralen Abmessungen. Als Widerstand ergibt sich R = 5 Ω/□, ρ=65 µΩcm. Die Abbildungen 10, 11 und 12 zeigen die entsprechenden rasterelektronenmikroskopischen Aufnahmen.

### Beispiel 4

### Herstellung von Palladium/Platin-Leiterbahnen unter Verwendung von 2 nm Bimetallkolloiden bzw. Bimetallclustern (27.12% Pd, 17.85% Pt)

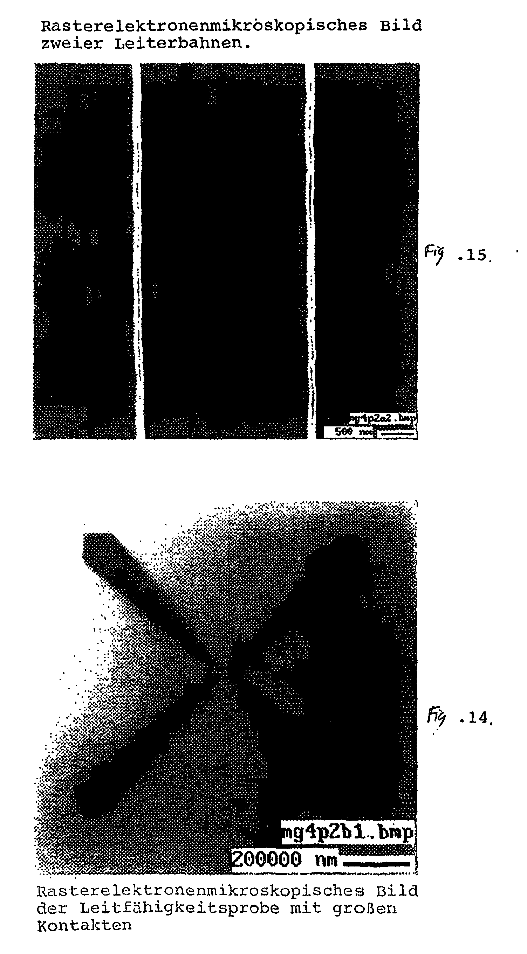

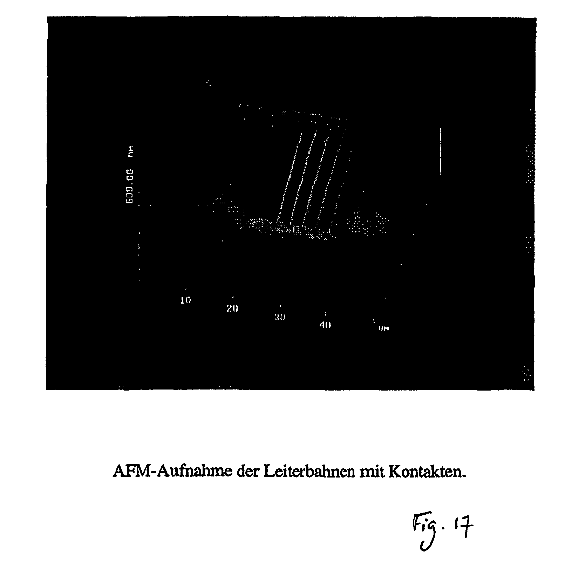

Unter Reinraumbedingungen wird zunächst eine Lösung von 150 mg Palladium/Platin-Tetraoctylammoniumbromid (Elementaranalyse: 27.12%% Pd, 17.85% Pt; die verbleibenden 54.00% bestehen aus Tetraoctylammoniumbromid, das als Stabilisator die Teilchen vor einer unerwünschten Agglomeration schützt) in 1 ml Tetrahydrofuran hergestellt. Die durch TEM ermittelte Größe der Kolloide liegt bei 6 nm bei sphärischer Geometrie. EDX-Spotanalysen zeigen, daß nahezu alle Kolloidpartikel beide Metalle enthalten. Auf zuvor in Aceton im Ultraschallbad gereinigten GaAs Substraten (3.9*3.9*0.5 mm) wird nun durch Aufschleudern ein Kolloidfilm erzeugt. Dafür werden 35 µl zuvor möglichst frisch filtrierter Kolloidlösung (Filtration durch 200 nm Teflonfilter) auf den GaAs-Wafer aufgetropft und der Aufschleuderprozess mit folgenden Parametern gestartet: Rotationsbeschleunigung 20000 Upm/s, Rotationsgeschwindigkeit 9000 Upm, Dauer 30 s.
Der Schreibvorgang erfolgt durch einbringen des GaAs-Wafers in ein Elektronenmikroskop und Belichten des Kolloidfilmes mit dem Elektronenstrahl. Als Layout wird eine Struktur bestehend aus fünf 20 nm breiten, 31 µm langen parallel verlaufenden Leiterbahnen gewählt, deren Enden durch Kontaktstreifen verbunden sind. Die Belichtung des GaAs-Wafers erfolgt im High-Magnification-Mode des Elektronenmikroskops jeweils mit folgenden Dosen: D=400000 µC/cm², D=600000 µC/cm², D=800000 µC/cm², wobei die Kontaktstreifen jeweils nur mit 10% der angegebenen Dosen belichtet werden. AFM-Untersuchungen der Proben zeigen, daß die Dosis D=800000 µC/cm² das beste Resultat zeigt. Zur besseren Kontaktierbarkeit werden an diese Struktur im Low-Magnification-Mode große Kontakte für eine Vierpunkt-Leitfähigkeitsmessung mit D=36000 µC/cm² auf den Kolloidfilm geschrieben. Die Entwicklung der Struktur erfolgt durch einfaches Waschen des GaAs-Wafers mit Tetrahydrofuran im Ultraschallbad, wobei der unbelichtete Kolloidfilm bedingt durch die Redispergierbarkeit des Pd/Pt-Kolloids weggewaschen wird, übrig bleiben die belichteten Bereiche. AFM-Untersuchung zeigt, daß Leiterbahnen von 31.812 µm Länge, 61 nm Breite und 54 nm Höhe mit zu gehörigen Kontakten geschrieben wurden. Durch Vierpunktmessung dieser Leiterbahnen ergibt sich R = 15.014 KΩ/□, ρ=81076.4 µΩcm. Zur Verbesserung der Leitfähigkeit wird der GaAs-Wafer anschließend bei 185 °C, P=1 mbar 120 min getempert. Dabei reduziert sich die Dicke der Struktur auf 41 nm bei gleichbleibenden lateralen Abmessungen. Als Widerstand ergibt sich R = 16.8 Ω/□, p=69.3 µΩcm. Die Abbildungen 13, 14 und 15 zeigen die entsprechenden rasterelektronenmikroskopischen Aufnahmen.

### Beispiel 5

### Herstellung von Palladium-Leiterbahnen unter Verwendung von 2 nm Kolloiden bzw. Clustern (6.06% Pd)

Unter Reinraumbedingungen wird zunächst eine Lösung von 50 mg Palladium-Polyvinylpyrrolidon (Elementaranalyse: 6.06% Pd; die verbleibenden 93.94% bestehen aus Polyvinylpyrrolidon, das als Stabilisator die Teilchen vor einer unerwünschten Agglomeration schützt) in 1 ml Dichlormethan hergestellt. Die durch TEM ermittelte Größe der Kolloide liegt bei 2 nm bei sphärischer Geometrie. Auf zuvor in Aceton im Ultraschallbad gereinigten GaAs Substraten (3.9*3.9*0.5 mm) wird nun durch Aufschleudern ein Kolloidfilm erzeugt. Dafür werden 35 µl zuvor möglichst frisch filtrierter Kolloidlösung (Filtration durch 200 nm Teflonfilter) auf den GaAs-Wafer aufgetropft und der Aufschleuderprozess mit folgenden Parametern gestartet: Rotationsbeschleunigung 20000 Upm/s, Rotationsgeschwindigkeit 9000 Upm, Dauer 30 s.
Der Schreibvorgang erfolgt durch einbringen des GaAs-Wafers in ein Elektronenmikroskop und Belichten des Kolloidfilmes mit dem Elektronenstrahl. Als Layout wird eine Struktur bestehend aus fünf 20 nm breiten, 31 µm langen parallel verlaufenden Leiterbahnen gewählt, deren Enden durch Kontaktstreifen verbunden sind. Die Belichtung des GaAs-Wafers erfolgt im High-Magnification-Mode des Elektronenmikroskops mit folgender Dosis: D=18000 µC/cm², wobei die Kontaktstreifen jeweils nur mit 10% der angegebenen Dosen belichtet werden. Zur besseren Kontaktierbarkeit werden an diese Struktur im Low-Magnification-Mode große Kontakte für eine Vierpunkt-Leitfähigkeitsmessung mit D=2500 µC/cm² auf den Kolloidfilm geschrieben. Die Entwicklung der Struktur erfolgt durch einfaches Waschen des GaAs-Wafers mit Dichlormethan im Ultraschallbad, wobei der unbelichtete Kolloidfilm bedingt durch die Redispergierbarkeit des Pd-Kolloids weggewaschen wird, übrig bleiben die belichteten Bereiche. AFM-Untersuchung zeigt, daß Leiterbahnen von 32.200 µm Länge, 230 nm Breite und 94 nm Höhe mit zugehörigen Kontakten geschrieben wurden. Durch Vierpunktmessung dieser Leiterbahnen ergibt sich R = 46.458 KΩ/□, ρ=436708 µΩcm. Zur Verbesserung der Leitfähigkeit wird der GaAs-Wafer anschließend bei 185 °C, P=1 mbar 120 min getempert. Dabei reduziert sich die Dicke der Struktur auf 72 nm bei gleichbleibenden lateralen Abmessungen. Als Widerstand ergibt sich R = 46.25 Ω/□, p=333 µΩcm. Die Abbildung 16 zeiget die rastekraftmikroskopische Aufnahme der erzeugten Leiterbahnen mit Kontakten.

### Beispiel 6

### Herstellung von Kupfer-Leiterbahnen unter Verwendung von 2 nm Kolloiden bzw. Clustern (8.21% Pd)

Unter Reinraumbedingungen wird zunächst eine Lösung von 50 mg Palladium-Polyvinylpyrrolidon (Elementaranalyse: 8.21% Cu; die verbleibenden 91.79% bestehen aus Polyvinylpyrrolidon, das als Stabilisator die Teilchen vor einer unerwünschten Agglomeration schützt) in 1 ml Dichlormethan hergestellt. Die durch TEM ermittelte Größe der Kolloide liegt bei 2 nm bei sphärischer Geometrie. Auf zuvor in Aceton im Ultraschallbad gereinigten GaAs Substraten (3.9*3.9*0.5 mm) wird nun durch Aufschleudern ein Kolloidfilm erzeugt. Dafür werden 35 µl zuvor möglichst frisch filtrierter Kolloidlösung (Filtration durch 200 nm Teflonfilter) auf den GaAs-Wafer aufgetropft und der Aufschleuderprozess mit folgenden Parametern gestartet: Rotationsbeschleunigung 10000 Upm/s, Rotationsgeschwindigkeit 9000 Upm, Dauer 30 s.
Der Schreibvorgang erfolgt durch einbringen des GaAs-Wafers in ein Elektronenmikroskop und Belichten des Kolloidfilmes mit dem Elektronenstrahl. Als Layout wird eine Struktur bestehend aus fünf 20 nm breiten, 31 µm langen parallel verlaufenden Leiterbahnen gewählt, deren Enden durch Kontaktstreifen verbunden sind. Die Belichtung des GaAs-Wafers erfolgt im High-Magnification-Mode des Elektronenmikroskops mit folgender Dosis: D=25000 µC/cm², wobei die Kontaktstreifen jeweils nur mit 10% der angegebenen Dosen belichtet werden. Die Entwicklung der Struktur erfolgt durch einfaches Waschen des GaAs-Wafers mit Dichlormethan im Ultraschallbad, wobei der unbelichtete Kolloidfilm bedingt durch die Redispergierbarkeit des Cu-Kolloids weggewaschen wird, übrig bleiben die belichteten Bereiche. AFM-Untersuchung zeigt, daß Leiterbahnen von 31.231 µm Länge, 112 nm Breite und 53 nm Höhe mit zugehörigen Kontakten geschrieben wurden.

### Beispiel 7

### Herstellung von Cobalt-Strukturen unter Verwendung von 2 nm Kolloiden bzw. Clustern (27.59% Co)

Da das Metallkolloid sehr luft- und feuchtigkeitsempfindlich ist, müssen alle nachfolgenden Operationen unter Schutzgasbedingungen durchgeführt werden. Unter Reinraumbedingungen wird zunächst eine Lösung von 150 mg Cobalt-Tetraoctylammoniumbromid (Elementaranalyse: 27.59% Co; die verbleibenden 72.41% bestehen aus Tetraoctylammoniumbromid, das als Stabilisator die Teilchen vor einer unerwünschten Agglomeration schützt) in 1 ml Tetrahydrofuran hergestellt. Die durch TEM ermittelte Größe der Kolloide liegt bei 2 nm bei sphärischer Geometrie. Auf zuvor in Aceton im Ultraschallbad gereinigten GaAs Substraten (3.9*3.9*0.5 mm) wird nun durch Aufschleudern ein Kolloidfilm erzeugt. Dafür werden 35 µl zuvor möglichst frisch filtrierter Kolloidlösung (Filtration durch 200 nm Teflonfilter) auf den GaAs-Wafer aufgetropft und der Aufschleuderprozess mit folgenden Parametern gestartet: Rotationsbeschleunigung 20000 Upm/s, Rotationsgeschwindigkeit 9000 Upm, Dauer 15 s.
Der Schreibvorgang erfolgt durch einbringen des GaAs-Wafers in ein Elektronenmikroskop und Belichten des Kolloidfilmes mit dem Elektronenstrahl. Als Layout wird eine Struktur bestehend aus fünf 20 nm breiten, 31 µm langen parallel verlaufenden Bahnen gewählt. Die Belichtung des GaAs-Wafers erfolgt im High-Magnification-Mode des Elektronenmikroskops mit folgender Dosis: D=600000 µC/cm². Die Entwicklung der Struktur erfolgt durch einfaches Waschen des GaAs-Wafers mit Dichlormethan im Ultraschallbad, wobei der unbelichtete Kolloidfilm bedingt durch die Redispergierbarkeit des Co-Colloids weggewaschen wird, übrig bleiben die belichteten Bereiche. AFM-Untersuchung zeigt, daß Strukturen von 31.899 µm Länge, 54 nm Breite und 66 nm Höhe geschrieben wurden.

### Beispiel 8

### Herstellung von Cobaltoxid-Strukturen unter Verwendung von 2.5 nm Kolloiden bzw. Clustern (21.34% Co)

Da das Metallkolloid sehr luft- und feuchtigkeitsempfindlich ist, müssen alle nachfolgenden Operationen unter Schutzgasbedingungen durchgeführt werden. Unter Reinraumbedingungen wird zunächst eine Lösung von 150 mg Cobaltoxid-Tetraoctylammoniumbromid (Elementaranalyse: 21.34% Co; die verbleibenden 78.66% bestehen aus Tetraoctylammoniumbromid, das als Stabilisator die Teilchen vor einer unerwünschten Agglomeration schützt) in 1 ml Tetrahydrofuran hergestellt. Die durch TEM ermittelte Größe der Kolloide liegt bei 2.5 nm bei sphärischer Geometrie. Auf zuvor in Aceton im Ultraschallbad gereinigten GaAs Substraten (3.9*3.9*0.5 mm) wird nun durch Aufschleudern ein Kolloidfilm erzeugt. Dafür werden 35 µl zuvor möglichst frisch filtrierter Kolloidlösung (Filtration durch 200 nm Teflonfilter) auf den GaAs-Wafer aufgetropft und der Aufschleuderprozess mit folgenden Parametern gestartet: Rotationsbeschleunigung 20000 Upm/s, Rotationsgeschwindigkeit 9000 Upm, Dauer 15 s.
Der Schreibvorgang erfolgt durch einbringen des GaAs-Wafers in ein Elektronenmikroskop und Belichten des Kolloidfilmes mit dem Elektronenstrahl. Als Layout wird eine Struktur bestehend aus fünf 20 nm breiten, 31 µm langen parallel verlaufenden Bahnen gewählt, Die Belichtung des GaAs-Wafers erfolgt im High-Magnification-Mode des Elektronenmikroskops mit folgender Dosis: D=500000 µC/cm². Die Entwicklung der Struktur erfolgt durch einfaches Waschen des GaAs-Wafers mit Tetrahydrofuran, wobei der unbelichtete Cobaltoxidfilm bedingt durch die Redispergierbarkeit des Co-Colloids weggewaschen wird, übrig bleiben die belichteten Bereiche. Untersuchungen zeigten, daß Strukturen von 31.021 µm Länge, 35 nm Breite und 71 nm Höhe geschrieben wurden.

### Beispiel 9

### Herstellung von Kupfer/Palladium-Strukturen unter Verwendung von 2 nm Bimetallkolloiden bzw. Bimetallclustern (31.38% Pd, 21.92%Cu)

Da das Metallkolloid sehr luft- und feuchtigkeitsempfindlich ist, müssen alle nachfolgenden Operationen unter Schutzgasbedingungen durchgeführt werden. Unter Reinraumbedingungen wird zunächst eine Lösung von 150 mg Palladium/Kupfer-Tetraoctylammoniumbromid (Elementaranalyse: 31.38% Pd, 21.92% Cu; die verbleibenden 46.70% bestehen aus Tetraoctylammoniumbromid, das als Stabilisator die Teilchen vor einer unerwünschten Agglomeration schützt) in 1 ml Tetrahydrofuran hergestellt. Die durch TEM ermittelte Größe der Kolloide liegt bei 2 nm bei sphärischer Geometrie. Auf zuvor in Aceton im Ultraschallbad gereinigten GaAs Substraten (3.9*3.9*0.5 mm) wird nun durch Aufschleudern ein Kolloidfilm erzeugt. Dafür werden 35 µl zuvor möglichst frisch filtrierter Kolloidlösung (Filtration durch 200 nm Teflonfilter) auf den GaAs-Wafer aufgetropft und der Aufschleuderprozess mit folgenden Parametern gestartet: Rotationsbeschleunigung 20000 Upm/s, Rotationsgeschwindigkeit 9000 Upm, Dauer 15 s.
Der Schreibvorgang erfolgt durch einbringen des GaAs-Wafers in ein Elektronenmikroskop und Belichten des Kolloidfilmes mit dem Elektronenstrahl. Als Layout wird eine Struktur bestehend aus fünf 20 nm breiten, 31 µm langen parallel verlaufenden Bahnen gewählt. Die Belichtung des GaAs-Wafers erfolgt im High-Magnification-Mode des Elektronenmikroskops mit folgender Dosis: D=300000 µC/cm². Die Entwicklung der Sruktur erfolgt durch einfaches Waschen des GaAs-Wafers mit Tetrahydrofuran wobei der unbelichtete Kolloidfilm bedingt durch die Redispergierbarkeit des Cu/Pd-Kolloids weggewaschen wird, übrig bleiben die belichteten Bereiche. Untersuchungen zeigten, daß Strukturen von 30.873 µm Länge, 64 nm Breite und 36 nm Höhe geschrieben wurden.

### Beispiel 10

### Herstellung von Palladium-Säulen unter Verwendung von 2 nm Kolloiden bzw. Clustern (68.80%Pd)

Unter Reinraumbedingungen wird zunächst eine Lösung von 150 mg Palladium-Tetraoctylammoniumbromid (Elementaranalyse: 68.80% Pd; die verbleibenden 31.2% bestehen aus Tetraoctylammoniumbromid, das als Stabilisator die Teilchen vor einer unerwünschten Agglomeration schützt) in 1 ml Tetrahydrofuran hergestellt. Die durch TEM ermittelte Größe der Kolloide liegt bei 2 nm bei sphärischer Geometrie. Auf zuvor in Aceton im Ultraschallbad gereinigten Si-Substraten (3.9*3.9*0.5 mm) wird nun durch Aufschleudern ein Kolloidfilm erzeugt. Dafür werden 35 µl zuvor möglichst frisch filtrierter Kolloidlösung (Filtration durch 200 nm Teflonfilter) auf den GaAs-Wafer aufgetropft und der Aufschleuderprozess mit folgenden Parametern gestartet: Rotationsbeschleunigung 20000 Upm/s, Rotationsgeschwindigkeit 9000 Upm, Dauer 15 s.
Der Schreibvorgang erfolgt durch einbringen des Si-Wafers in ein Elektronenmikroskop und Belichten des Kolloidfilmes mit dem Elektronenstrahl. Als Layout wird eine Struktur bestehend aus neun ausgefüllten Kreisen von 1 µm bis 200 nm Durchmesser gewählt. Die Belichtung des Si-Wafers erfolgt im High-Magnification-Mode des Elektronenmikroskops mit folgender Dosis: D=400000 µC/cm². Die Entwicklung der Struktur erfolgt durch einfaches Waschen des Si-Wafers mit Tetrahydrofuran, wobei der unbelichtete Kolloidfilm bedingt durch die Redispergierbarkeit des Pd-Kolloids weggewaschen wird, übrig bleiben die belichteten Bereiche. Untersuchungen zeigten, daß alle Kreise mit einer Höhe von 120 nm geschrieben wurden.

### Beispiel 11

### Herstellung von Gold-Strukturen unter Verwendung von 3-12 nm Kolloiden bzw. Clustern (21.56% Au)

Da das Metallkolloid sehr luft- und feuchtigkeitsempfindlich ist, müssen alle nachfolgenden Operationen unter Schutzgasbedingungen durchgeführt werden. Unter Reinraumbedingungen wird zunächst eine Lösung von 150 mg Gold-Tetraoctylammoniumbromid (Elementaranalyse: 21.56% Au; die verbleibenden 78.44% bestehen aus Tetraoctylammoniumbromid, das als Stabilisator die Teilchen vor einer unerwünschten Agglomeration schützt) in 1 ml Tetrahydrofuran hergestellt. Die durch TEM ermittelte Größe der Kolloide liegt bei 3-12 nm bei sphärischer Geometrie. Auf zuvor in Aceton im Ultraschallbad gereinigten GaAs Substraten (3.9*3.9*0.5 mm) wird nun durch Aufschleudern ein Kolloidfilm erzeugt. Dafür werden 35 µl zuvor möglichst frisch filtrierter Kolloidlösung (Filtration durch 200 nm Teflonfilter) auf den GaAs-Wafer aufgetropft und der Aufschleuderprozess mit folgenden Parametern gestartet: Rotationsbeschleunigung 20000 Upm/s, Rotationsgeschwindigkeit 9000 Upm, Dauer 15 s.
Der Schreibvorgang erfolgt durch einbringen des GaAs-Wafers in ein Elektronenmikroskop und Belichten des Kolloidfilmes mit dem Elektronenstrahl. Als Layout wird eine Struktur bestehend aus fünf 20 nm breiten, 31 µm langen parallel verlaufenden Bahnen gewählt, Die Belichtung des GaAs-Wafers erfolgt im High-Magnification-Mode des Elektronenmikroskops mit folgender Dosis: D=600000 µC/cm². Die Entwicklung der Struktur erfolgt durch einfaches Waschen des GaAs-Wafers mit Tetrahydrofuran im Ultraschallbad, wobei der unbelichtete Kolloidfilm bedingt durch die Redispergierbarkeit des Au-Kolloids weggewaschen wird, übrig bleiben die belichteten Bereiche. Untersuchungen zeigten, daß Strukturen von 30.356 µm Länge, 94 nm Breite und 39 nm Höhe geschrieben wurden.

## Patentansprüche

1. Lithographisches Verfahren zur Erzeugung von Nanostrukturen auf Oberflächen, **dadurch gekennzeichnet, daß** stabilisierte Nanometer-große Übergangsmetall-Cluster bzw. Kolloide von Metallen der Gruppen 4, 5, 6, 7, 8, 9, 10, 11 oder 12 des Periodensystems, oder deren stabilisierte Metalloxidoder Metallsulfid-Analoga, jeweils in Form einer Lösung, auf eine Oberfläche als Film aufgetragen werden und dieser mit einem Elektronenstrahl gezielt belichtet wird, wobei nach Wegwaschen der nicht-belichteten Teile des Films, ggf. gefolgt von Tempern, definierte Strukturen auf der Oberfläche im Nanometerbereich erzeugt werden.

2. Verfahren nach Anspruch 1, **dadurch gekennzeichnet, daß** lösliche Nanometer-große, durch Tetraalkylammoniumsalz-stabilisierte Übergangsmetall-Cluster bzw. Kolloide der Gruppen 4, 5, 6, 7, 8, 9, 10, 11 oder 12 des Periodensystems als Precursor bzw. Metallquelle verwendet werden.

3. Verfahren nach den Ansprüchen 1 und 2, **dadurch gekennzeichnet, daß** die analogen Ammonium-stabilisierten Bimetall-Cluster oder. Bimetall -Kolloide der Gruppen 4, 5, 6, 7, 8, 9, 10, 11 oder 12 eingesetzt werden.

4. Verfahren nach den Anspruch 1, **dadurch gekennzeichnet, daß** lösliche Nanometer-große, durch Polymere wie Polyvinylpyrrolidon stabilisierte Metall-Cluster bzw. -Kolloide der Gruppen 4, 5, 6, 7, 8, 9, 10, 11 oder 12 des Periodensystems als Precursor bzw. Metallquelle verwendet werden.

5. Verfahren nach Ansprüchen 1 und 4, **dadurch gekennzeichnet, daß** die Polymer-stabilisierten Bimetall-Cluster oder Bimetall-Kolloide der Übergangsmetalle der Gruppen 4, 5, 6, 7, 8, 9, 10, 11 oder 12 eingesetzt werden.

6. Verfahren nach Anspruch 1, **dadurch gekennzeichnet, daß** lösliche nanostrukturierte Metalloxid- und Metallsulfid-Cluster bzw. -Kolloide aus Metallen der Gruppen 4, 5, 6, 7, 8, 9, 10, 11 oder 12 des Periodensystems, ggf. stabilisiert durch Tenside wie Tetraalkylammoniumsalze, Polymere oder Liganden, als Precursor eingesetzt werden.

7. Verfahren nach Anspruch 1, **dadurch gekennzeichnet, daß** als Lösungsmittel THF, Toluol, Dimethylformamid, Ethanol, Aceton oder Wasser zum Auftragen und Wegwaschen der Filme verwendet werden.

8. Verfahren nach den Ansprüchen 1 bis 6, **dadurch gekennzeichnet, daß** Substrate wie Si-, GaAs- oder SnO₂-Wafer als Oberflächen verwendet werden.

9. Verfahren nach den Ansprüchen 1 und 8, **dadurch gekennzeichnet, daß** die Größe der Substrate im Bereich von 0.05 bis 4 cm² beträgt.

10. Verfahren nach den Ansprüchen 1 bis 6, **dadurch gekennzeichnet, daß** die Metall-Cluster- bzw. Metall-Kolloid- oder Metalloxid- bzw. Metallsulfidhaltigen Filme eine Schichtdicke von 0.3 nm bis 2 µm haben.

11. Verfahren nach Anspruch 1, **dadurch gekennzeichnet, daß** ein Elektronenstrahl so über den Metall-haltigen Film gezielt gelenkt bzw. gefahren wird, daß an den belichteten Stellen Nanostrukturen mit gewünschten geometrischen Eigenschaften (Linien oder Punkte bzw. Säulen) entstehen, die nach dem Wegwaschen der nicht belichteten Stellen des Films gemäß Anspruch 11 freigesetzt bzw. sichtbar werden.

12. Verfahren nach Anspruch 1, **dadurch gekennzeichnet, daß** die Nanostrukturen im Zuge eines Tempern bei 150 - 400 °C, ggf. in einem H₂-Strom, zur weiteren Reinigung und zur Erhöhung der Leitfähigkeit nachbehandelt werden, unter Bildung von Leiterbahnen mit optimalen Leitfähigkeitseigenschaften.

13. Verfahren nach den Ansprüchen 1 bis 12, **dadurch gekennzeichnet, daß** die Größe der Nanostrukturen u. a. durch die Wahl besonders dünner Filme und Verwendung von Rasterelektronenmikroskopen höchster Auflösung als Elektronenstrahlquelle bis auf 10 nm reduziert werden kann, während die Erzeugung größerer Strukturen bis in den Mikrometerbereich durch Verwendung dickerer Filme und gezielt flächendeckender Bestrahlung möglich ist.

## Claims

1. A lithographic method for the generation of nanostructures on surfaces, **characterized in that** either stabilized nanometer-sized transition metal clusters or colloids of metals of groups 4, 5, 6, 7, 8, 9, 10, 11 or 12 of the Periodic Table, their stabilized metal oxide or metal sulfide analogues, respectively in the form of a solution, are coated on a surface as a film which is imagewise exposed with an electron beam, wherein defined structures in the nanometer range are generated on the surface after washing off the unexposed portions of the film, optionally followed by annealing.

2. The method according to claim 1, **characterized in that** soluble nanometer-sized tetraalkylammonium salt stabilized transition metal clusters or colloids of groups 4, 5, 6, 7, 8, 9, 10, 11 or 12 of the Periodic Table are used as the precursor or metal source.

3. The method according to claims 1 and 2, **characterized in that** the analogous ammonium stabilized bimetallic clusters or bimetallic colloids of groups 4, 5, 6, 7, 8, 9, 10, 11 or 12 are used.

4. The method according to claim 1, **characterized in that** soluble nanometer-sized metal clusters or colloids of groups 4, 5, 6, 7, 8, 9, 10, 11 or 12 of the Periodic Table, stabilized by polymers such as polyvinylpyrrolidone, are used as the precursor or metal source.

5. The method according to claims 1 and 4, **characterized in that** the polymer-stabilized bimetallic clusters or bimetallic colloids of the transition metals of groups 4, 5, 6, 7, 8, 9, 10, 11 or 12 are used.

6. The method according to claim 1, **characterized in that** soluble nanostructured metal oxide and metal sulfide clusters or colloids of metals of groups 4, 5, 6, 7, 8, 9, 10, 11 or 12 of the Periodic Table, optionally stabilized by surfactants, such as tetraalkylammonium salts, polymers or ligands, are used as the precursor.

7. The method according to claim 1, **characterized in that** solvents such as THF, toluene, dimethylformamide, ethanol, acetone or water are used for the coating and washing off of the films.

8. The method according to claims 1 to 6, **characterized in that** substrates such as Si, GaAs or SnO₂ wafers are used as the surfaces.

9. The method according to claims 1 and 8, **characterized in that** the size of the substrates is in the range of from 0.05 to 4 cm².

10. The method according to claims 1 to 6, **characterized in that** said metal cluster or metal colloid or metal oxide or metal sulfide containing films have a layer thickness of from 0.3 nm to 2 µm.

11. The method according to claim 1, **characterized in that** an electron beam is imagewise directed or driven over the metal containing film in such a way that nanostructures with desired geometric properties (lines or dots or columns) are formed at the exposed areas, which are stripped and become visible after the washing off of the unexposed areas of the film according to claim 11.

12. The method according to claim 1, **characterized in that** the nanostructures are subjected to an aftertreatment by annealing at 150 to 400 °C, optionally in an H₂ flow, for further purification and for increasing the conductivity, to form conductor tracks with optimum conductivity properties.

13. The method according to claims 1 to 12, **characterized in that** the size of the nanostructures can be reduced down to 10 nm, inter alia, by selecting particularly thin films and using scanning electron microscopes of maximum resolution as the electron beam source, while the generation of larger structures up to the micrometer range is possible through the use of thicker films and a well-aimed area-covering irradiation.

## Revendications

1. Procédé lithographique de génération de nanostructures sur des surfaces, **caractérisé en ce que** des agrégats ou des colloïdes de métaux de transition, stabilisés et présentant une taille de l'ordre du nanomètre, issus des métaux des groupes 4, 5, 6, 7, 8, 9, 10, 11 ou 12 de la classification périodique des éléments, ou leurs analogues stabilisés d'oxyde métallique ou de sulfure métallique, respectivement sous la forme d'une solution, sont appliqués sur une surface en tant que film, et **en ce que** celui-ci est exposé de façon ciblée à un faisceau électronique, suite à quoi, après enlèvement par lavage des parties non exposées du film, éventuellement suivi par une trempe, des structures définies sont générées sur la surface, dans la gamme du nanomètre.

2. Procédé selon la revendication 1, **caractérisé en ce que** de l'on utilise, en tant que précurseur ou source de métal, des agrégats ou des colloïdes de métaux de transition des groupes 4, 5, 6, 7, 8, 9, 10, 11 ou 12 de la classification périodique des éléments, de l'ordre du nanomètre, solubles et stabilisés par un sel de tétraalkylammonium.

3. Procédé selon les revendications 1 et 2, **caractérisé en ce que** l'on utilise les agrégats bi-métalliques ou les colloïdes bi-métalliques analogues des groupes 4, 5, 6, 7, 8, 9, 10, 11 ou 12, stabilisés à l'ammonium.

4. Procédé selon la revendication 1, **caractérisé en ce que** l'on utilise, en tant que précurseur ou source de métal, des agrégats ou des colloïdes de métaux des groupes 4, 5, 6, 7, 8, 9, 10, 11 ou 12 de la classification périodique des éléments, solubles, de l'ordre du nanomètre, stabilisés par des polymères tels que la polyvinylpyrrolidone.

5. Procédé selon les revendications 1 et 4, **caractérisé en ce que** l'on utilise les agrégats bi-métalliques ou les colloïdes bi-métalliques des métaux de transition des groupes 4, 5, 6, 7, 8, 9, 10, 11 ou 12, stabilisés par un polymère.

6. Procédé selon la revendication 1, **caractérisé en ce que** l'on utilise, en tant que précurseur, des agrégats ou des colloïdes d'oxyde métallique ou de sulfure métallique, solubles et nanostructurés, issus des métaux des groupes 4, 5, 6, 7, 8, 9, 10, 11 ou 12 de la classification périodique des éléments, éventuellement stabilisés par des tensioactifs tels que des sels de tétraalkylammonium, des polymères ou des ligands.

7. Procédé selon la revendication 1, **caractérisé en ce que** l'on utilise en tant que solvant du THF, du toluène, du diméthylformamide, de l'éthanol, de l'acétone ou de l'eau pour l'application et l'enlèvement par lavage des films.

8. Procédé selon les revendications 1 à 6, **caractérisé en ce que** l'on utilise en tant que surfaces des substrats tels que des tranches de Si, GaAs ou SnO₂.

9. Procédé selon les revendications 1 et 8, **caractérisé en ce que** la taille des substrats est comprise dans la gamme allant de 0,05 à 4 cm².

10. Procédé selon les revendications 1 à 6, **caractérisé en ce que** les films contenant des agrégats métalliques ou des colloïdes métalliques ou de l'oxyde métallique ou du sulfure métallique présentent une épaisseur de couche comprise entre 0,3 nm et 2 µm.

11. Procédé selon la revendication 1, **caractérisé en ce qu'**un faisceau électronique est orienté ou conduit de façon ciblée sur le film contenant du métal de façon telle que se forment au niveau des emplacements exposés des nanostructures présentant des propriétés géométriques souhaitées (lignes, points ou colonnes), qui sont dégagées ou visibles, après élimination par lavage des emplacements non exposés du film, selon la revendication 11.

12. Procédé selon la revendication 1, **caractérisé en ce que** les nanostructures, suite à une trempe à une température comprise entre 150 et 400 °C, éventuellement dans un flux de H₂, subissent un traitement ultérieur pour mieux purifier et augmenter la conductibilité, en formant des pistes conductrices présentant des propriétés optimales de conductibilité.

13. Procédé selon les revendications 1 à 12, **caractérisé en ce que** la taille des nanostructures peut être réduite jusqu'à 10 nm entre autres par la sélection de films particulièrement minces et l'utilisation de microscopes électroniques à balayage de très grande résolution en tant que source de faisceau électronique, tandis que la génération de structures plus grandes jusqu'à la gamme des microns est possible par l'utilisation de films plus épais et une irradiation ciblée de recouvrement de surface.
